# EUROPEAN PATENT SPECIFICATION

(11) **EP 2 376 595 B1**
(45) Date of publication and mention of the grant of the patent: **21.01.2015**
(21) Application number: 09835774.2
(22) Date of filing: 22.12.2009
(51) Int. Cl.: C09K 11/06, H01L 51/50

(54) **PHOTOACTIVE COMPOSITION AND ELECTRONIC DEVICE MADE WITH THE COMPOSITION**
FOTOAKTIVE ZUSAMMENSETZUNG UND MIT DER ZUSAMMENSETZUNG HERGESTELLTE ELEKTRONISCHE VORRICHTUNG
COMPOSITION PHOTOACTIVE ET DISPOSITIF ÉLECTRONIQUE FAIT AVEC LADITE COMPOSITION

(30) Priority: 22.12.2008 US 139820 P
(43) Date of publication of application: 19.10.2011
(73) Proprietor: E. I. du Pont de Nemours and Company, Wilmington, DE 19898 (US)
(72) Inventor: HERRON, Norman, Newark Delaware 19711 (US); WANG, Ying, Wilmington Delaware 19810 (US)
(74) Representative: Hoffmann, Benjamin
(86) International application number: PCT/US2009/069240
(87) International publication number: WO 2010/075411

(56) References cited:
- WO-A2-2010/068865
- US-A1- 2006 099 447
- US-A1- 2006 099 447
- US-A1- 2006 103 298
- US-A1- 2006 103 298
- US-A1- 2006 199 038
- US-A1- 2006 199 038
- US-A1- 2007 037 983
- US-A1- 2007 037 983
- US-A1- 2008 284 317
- US-A1- 2008 284 317

## Description

### BACKGROUND INFORMATION

### Field of the Disclosure

This disclosure relates in general to photoactive compositions that are useful in organic electronic devices.

### Description of the Related Art

In organic photoactive electronic devices, such as organic light emitting diodes ("OLED"), that make up OLED displays, the organic active layer is sandwiched between two electrical contact layers in an OLED display. In an OLED, the organic photoactive layer emits light through the light-transmitting electrical contact layer upon application of a voltage across the electrical contact layers.

It is well known to use organic electroluminescent compounds as the active component in light-emitting diodes. Simple organic molecules, conjugated polymers, and organometallic complexes have been used.

Devices that use photoactive materials frequently include one or more charge transport layers, which are positioned between a photoactive (e.g., light-emitting) layer and a contact layer (hole-injecting contact layer). A device can contain two or more contact layers. A hole transport layer can be positioned between the photoactive layer and the hole-injecting contact layer. The hole-injecting contact layer may also be called the anode. An electron transport layer can be positioned between the photoactive layer and the electron-injecting contact layer. The electron-injecting contact layer may also be called the cathode. Charge transport materials can also be used as hosts in combination with the photoactive materials.

There is a continuing need for new materials for electronic devices.

### SUMMARY

There is provided a photoactive composition comprising: (a) a first host material comprising a phenanthroline derivative; (b) a second host material comprising an aromatic amine having a HOMO level of -5.4 eV ± 0.2 eV; and (c) an electroluminescent dopant material; wherein the weight ratio of first host material to second host material is in the range of 99:1 to 50:50,
characterised in that
the first host has Formula I: 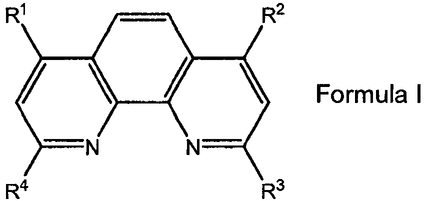 wherein R¹ to R⁴ are independently selected from the group consisting of naphthyl, naphthylphenyl, phenylnaphthyl, carbazolyl, carbozolylphenyl, triphenylamino, arylanthracenyl, and a group having Formula II: 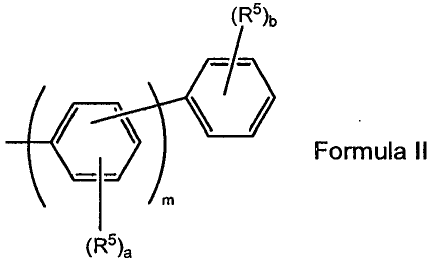 where:
R⁵ is the same or different at each occurrence and is selected from the group consisting of D, alkyl, alkoxy, and aryl;
a is the same or different at each occurrence and is an integer from 0-4;
b is the same or different at each occurrence and is an integer from 0-5; and
m is the same or different at each occurrence and is an integer from 0 to 6.

There is also provided an organic electronic device comprising an anode, a hole transport layer, a photoactive layer, an electron transport layer, and a cathode, wherein the photoactive layer comprises the photoactive composition described above.

The foregoing general description and the following detailed description are exemplary and explanatory only and are not restrictive of the invention, as defined in the appended claims.

### BRIEF DESCRIPTION OF THE DRAWINGS

Embodiments are illustrated in the accompanying figures to improve understanding of concepts as presented herein.

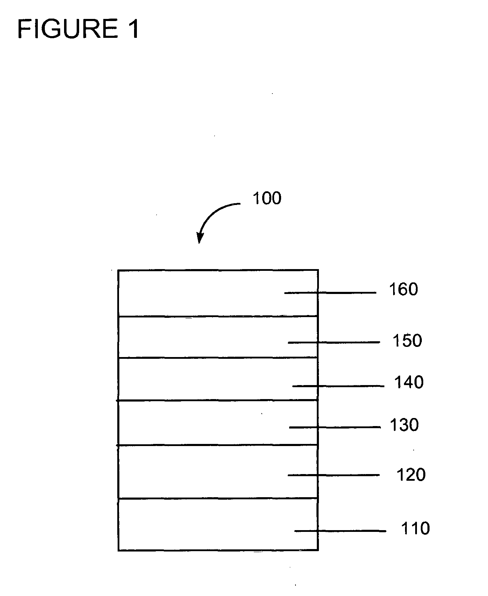

FIG. 1 includes an illustration of an exemplary organic device.

Skilled artisans appreciate that objects in the figures are illustrated for simplicity and clarity and have not necessarily been drawn to scale. For example, the dimensions of some of the objects in the figures may be exaggerated relative to other objects to help to improve understanding of embodiments.

### DETAILED DESCRIPTION

Other features and benefits of any one or more of the embodiments will be apparent from the following detailed description, and from the claims. The detailed description first addresses Definitions and Clarification of Terms followed by the Photoactive Composition, the Electronic Device, and finally Examples.

### 1. Definitions and Clarification of Terms

Before addressing details of embodiments described below, some terms are defined or clarified.

The term "alkyl" is intended to mean a group derived from an aliphatic hydrocarbon. In some embodiments, the alkyl group has from 1-20 carbon atoms.

The term "aryl" is intended to mean a group derived from an aromatic hydrocarbon. The term "aromatic compound" is intended to mean an organic compound comprising at least one unsaturated cyclic group having delocalized pi electrons. The term is intended to encompass both aromatic compounds having only carbon and hydrogen atoms (referred to as "hydrocarbon aromatics"), and heteroaromatic compounds wherein one or more of the carbon atoms within the cyclic group has been replaced by another atom, such as nitrogen, oxygen, sulfur, or the like. In some embodiments, the aryl group has from 4-60 carbon atoms.

The term "charge transport," when referring to a layer, material, member, or structure is intended to mean such layer, material, member, or structure facilitates migration of such charge through the thickness of such layer, material, member, or structure with relative efficiency and small loss of charge. Hole transport materials facilitate positive charge; electron transport material facilitate negative charge. Although light-emitting materials may also have some charge transport properties, the term "charge transport layer, material, member, or structure" is not intended to include a layer, material, member, or structure whose primary function is light emission.

The term "dopant" is intended to mean a material, within a layer including a host material, that changes the electronic characteristic(s) or the targeted wavelength(s) of radiation emission, reception, or filtering of the layer compared to the electronic characteristic(s) or the wavelength(s) of radiation emission, reception, or filtering of the layer in the absence of such material.

The term "fused aryl" refers to an aryl group having two or more fused aromatic rings.

The term "HOMO" refers to the highest occupied molecular orbital. The HOMO energy level is measured relative to vacuum level. By convention, the HOMO is given as a negative value, i.e. the vacuum level is set as zero and the bound electron energy levels are deeper, and more negative, than this. Methods for determining the HOMO energy level are well known and understood. In some embodiments, the level is determined by ultraviolet photoelectron spectroscopy ("UPS").

The term "host material" is intended to mean a material, usually in the form of a layer, to which a dopant may or may not be added. The host material may or may not have electronic characteristic(s) or the ability to emit, receive, or filter radiation.

The term "layer" is used interchangeably with the term "film" and refers to a coating covering a desired area. The term is not limited by size. The area can be as large as an entire device or as small as a specific functional area such as the actual visual display, or as small as a single sub-pixel. Layers and films can be formed by any conventional deposition technique, including vapor deposition, liquid deposition (continuous and discontinuous techniques), and thermal transfer. Continuous deposition techniques, include but are not limited to, spin coating, gravure coating, curtain coating, dip coating, slot-die coating, spray coating, and continuous nozzle coating. Discontinuous deposition techniques include, but are not limited to, ink jet printing, gravure printing, and screen printing.

The term "organic electronic device," or sometimes just "electronic device," is intended to mean a device including one or more organic semiconductor layers or materials.

The term "photoactive" is intended to mean a material or layer that emits light when activated by an applied voltage (such as in a light emitting diode or chemical cell) or responds to radiant energy and generates a signal with or without an applied bias voltage (such as in a photodetector).

The term "silyl" refers to the group -SiR₃, where R is the same or different at each occurrence and is selected from the group consisting of alkyl groups, and aryl groups.

Unless otherwise indicated, all groups can be unsubstituted or substituted. Unless otherwise indicated, all groups can be linear, branched or cyclic, where possible. In some embodiments, the substituents are selected from the group consisting of alkyl, alkoxy, aryl, and silyl.

As used herein, the terms "comprises," "comprising," "includes," "including," "has," "having" or any other variation thereof, are intended to cover a non-exclusive inclusion. For example, a process, method, article, or apparatus that comprises a list of elements is not necessarily limited to only those elements but may include other elements not expressly listed or inherent to such process, method, article, or apparatus. Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

Also, use of "a" or "an" are employed to describe elements and components described herein. This is done merely for convenience and to give a general sense of the scope of the invention. This description should be read to include one or at least one and the singular also includes the plural unless it is obvious that it is meant otherwise.

Group numbers corresponding to columns within the Periodic Table of the elements use the "New Notation" convention as seen in the *CRC Handbook of Chemistry and Physics,* 81^{st} Edition (2000-2001).

Unless otherwise defined, all technical and scientific terms used herein have the same meaning as commonly understood by one of ordinary skill in the art to which this invention belongs. Although methods and materials similar or equivalent to those described herein can be used in the practice or testing of embodiments of the present invention, suitable methods and materials are described below. In addition, the materials, methods, and examples are illustrative only and not intended to be limiting.

To the extent not described herein, many details regarding specific materials, processing acts, and circuits are conventional and may be found in textbooks and other sources within the organic light-emitting diode display, photodetector, photovoltaic, and semiconductive member arts.

### 2. Photoactive Composition

Quinolate complexes of aluminum have been used as host materials in photoactive layers. Complexes such as bis(2-methyl-8-quinolinolato)(p-phenylphenolato) aluminum ("BAlq") have been used resulting in devices with high efficiency. However, Balq compounds are air and moisture sensitive. Potential substitutes such as Ga-quinolate complexes have better air and moisture stability. However, they result in lower device performance.

The photoactive compositions described herein comprise: (a) a first host material comprising a phenanthroline derivative; (b) a second host material comprising an aromatic amine having a HOMO level of -5.4 eV ± 0.2 eV; and (c) an electroluminescent dopant material; wherein the weight ratio of first host material to second host material is in the range of 99:1 to 50:50,
characterised in that
the first host has Formula I: 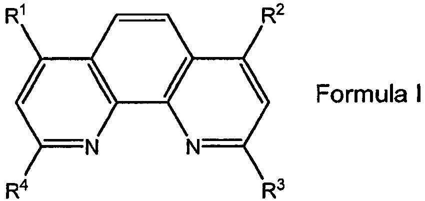 wherein R¹ to R⁴ are independently selected from the group consisting of naphthyl, naphthylphenyl, phenylnaphthyl, carbazolyl, carbozolylphenyl, triphenylamino, arylanthracenyl, and a group having Formula II: 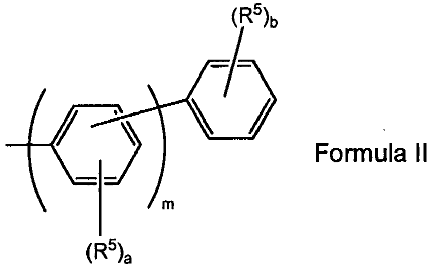 where:
R⁵ is the same or different at each occurrence and is selected from the group consisting of D, alkyl, alkoxy, and aryl;
a is the same or different at each occurrence and is an integer from 0-4;
b is the same or different at each occurrence and is an integer from 0-5; and
m is the same or different at each occurrence and is an integer from 0 to 6.

In some embodiments, the ratio of first host material to second host material is in the range of 95:5 to 60:40. In some embodiments, the ratio is in the range of 90:10 to 70:30.

In some embodiments, the weight ratio of total host material (first host + second host) to the dopant is in the range of 5:1 to 25:1; in some embodiments, from 10:1 to 20:1.

In some embodiments, the photoactive composition comprises two or more electroluminescent dopant materials. In some embodiments, the composition comprises three dopants.

In some embodiments, the photoactive composition consists essentially of the first host material, the second host material, and one or more electroluminescent dopant materials, as defined and in the ratios described above.

### a. First Host Material

The first host material is a phenanthroline derivative. Many such materials are known including bathophenanthroline and bathocuproine.

In some embodiments, the phenanthroline has aryl substituents at the 2- and 9-positions.

The first host material is a phenanthroline compound having Formula I: 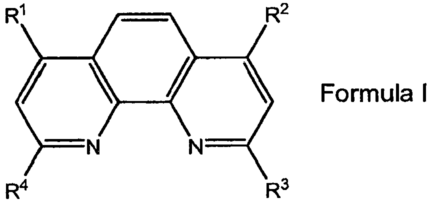 where:
R¹ through R⁴ are the same or different and are independently selected from the group consisting of naphthyl, naphthylphenyl, phenylnaphthyl, carbazolyl, carbozolylphenyl, triphenylamino, arylanthracenyl, and a group having Formula II: 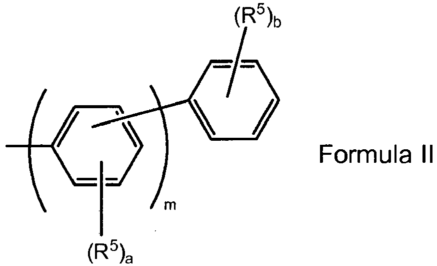 where:
   R⁵ is the same or different at each occurrence and is selected from the group consisting of D, alkyl, alkoxy, and aryl;
   a is the same or different at each occurrence and is an integer from 0-4;
   b is the same or different at each occurrence and is an integer from 0-5; and
   m is the same or different at each occurrence and is an integer from 0 to 6.

In some embodiments, R¹ to R⁴ have Formula IIa: 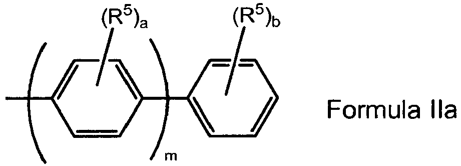 where R⁵, a, b, and m are as defined above.

In some embodiments of Formula I, R¹ to R⁴ are independently selected from the group consisting of phenyl, biphenyl, terphenyl, quaterphenyl, naphthyl, phenanthryl, naphthylphenyl, phenanthrylphenyl, carbazolyl, and carbazolylphenyl. Analogs higher than quaterphenyl can also be used, having 5-10 phenyl rings.

The groups referred to above are defined as follows, where the dashed lines represent possible points of attachment.
biphenyl: 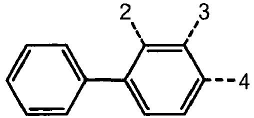 naphthyl: 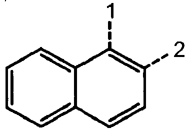 naphthylyphenyl: 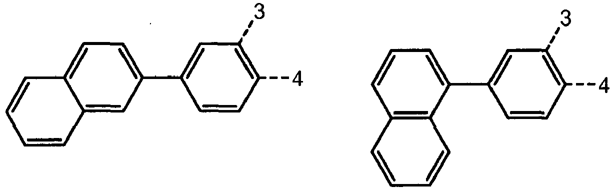 phenanthryl: 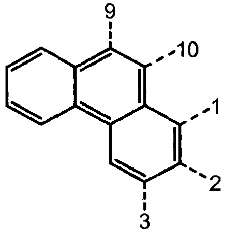 triphenylamino: 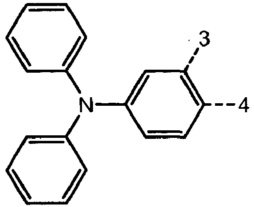 carbazolylphenyl: 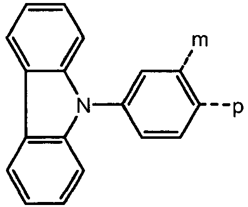 arylanthracenyl: 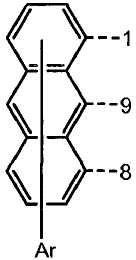 phenanthrylphenyl:

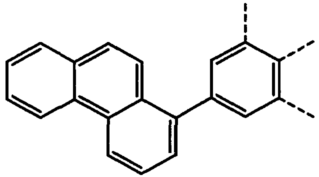

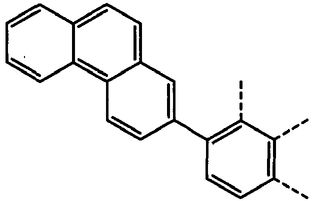

In some embodiments of Formula I, R¹ to R⁴ are selected from the group consisting of phenyl and substituted phenyl.

In some embodiments of Formula I, both R¹ and R² are phenyl and R³ and R⁴ are selected from the group consisting of 2-naphthyl, naphthylphenyl, phenanthryl, triphenylamino, and m-carbazolylphenyl.

In some embodiments, at least one of R¹ to R⁴ has at least one substituent. Substituent groups can be present in order to alter the physical or electronic properties of the host material. In some embodiments, the substituents improve the processibility of the host material. In some embodiments, the substituents increase the solubility and/or increase the Tg of the host material. In some embodiments, the substituents are selected from the group consisting of alkyl groups, alkoxy groups, silyl groups, and combinations thereof.

In some embodiments, the phenanthroline compounds are symmetrical, where R¹ = R² and R³ = R⁴. In some embodiments, R¹ = R² = R³ = R⁴. In some embodiments, the phenanthroline compounds are non-symmetrical, where R¹ = R² but, R³ ≠ R⁴; where R¹ ≠ R² and R³ = R⁴; or where R¹ ≠ R² and R² ≠ R³.

In some embodiments, R¹ = R² and are selected from the group consisting of phenyl, triphenylamino, and carbazolylphenyl. In some embodiments, R¹ and R² are selected from p-triphenylamino (where the point of attachment is para to the nitrogen) and m-carbazolylphenyl (where the point of attachment is meta to the nitrogen).

In some embodiments, R³ = R⁴ and is selected from the group consisting of triphenylamino, naphthylphenyl, triphenylamino, and m-carbazolylphenyl.

Examples of first host phenanthroline derivatives include, but are not limited to, compounds A1 to A5 below.

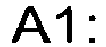

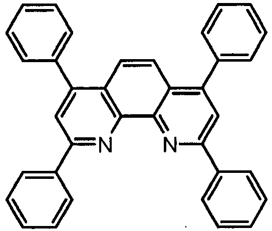

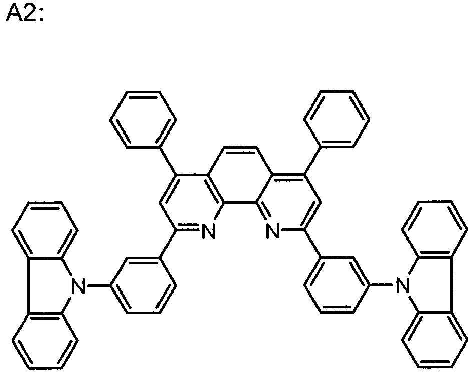

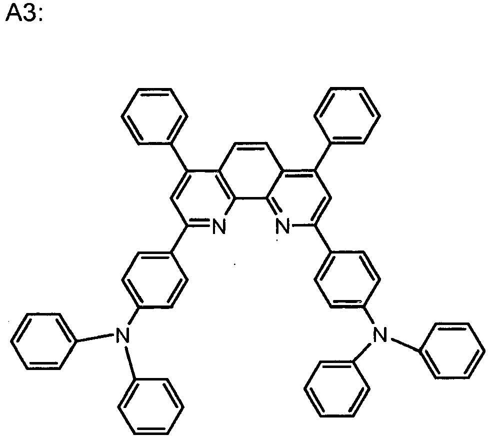

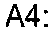

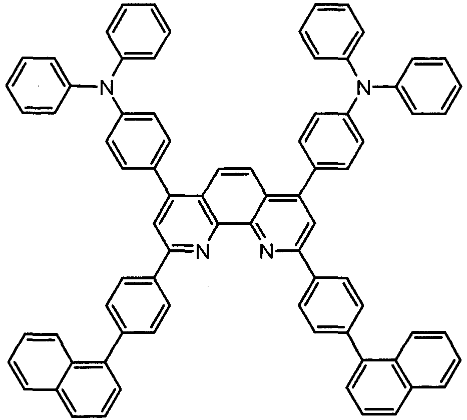

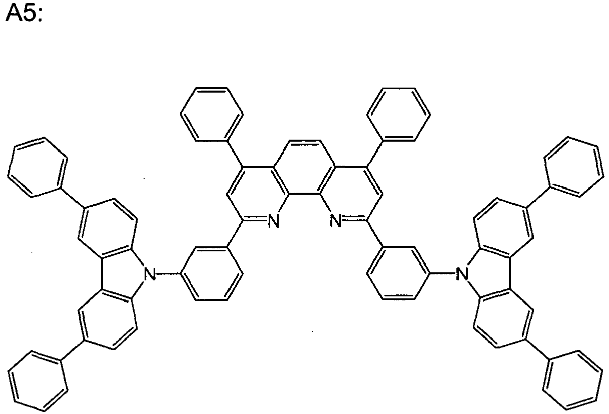

The first host compounds can be made by known synthetic techniques. Some phenanthroline derivatives are commercially available. This is further illustrated in the examples. In some embodiments, the phenanthroline host compounds are made by Suzuki coupling of dichloro phenanthrolines with the boronic acid analog of the desired substituent.

### b. Second Host Compound

The second host compound is an aromatic amine having HOMO level of -5.4 eV ± 0.2 eV.

The aromatic amine may have one or more amino nitrogens, each of which is bonded to three aromatic groups. Such types of compounds are well-known. Examples of aromatic amine compounds include, but are not limited to N,N'-diphenyl-N,N'-bis(3-methylphenyl)-[1,1'-biphenyl]-4,4'-diamine (TPD); 1,1-bis[(di-4-tolylamino) phenyl]cyclohexane (TAPC); N,N'-bis(4-methylphenyl)-N,N'-bis(4-ethylphenyl)-[1,1'-(3,3'-dimethyl)biphenyl]-4,4'-diamine (ETPD); tetrakis-(3-methylphenyl)-N,N,N',N'-2,5-phenylenediamine (PDA); triphenylamine (TPA), bis[4-(N,N-diethylamino)-2-methylphenyl](4-methylphenyl)methane (MPMP); N,N,N',N'-tetrakis(4-methylphenyl)-(1,1'-biphenyl)-4,4'-diamine (TTB); N,N'-bis(naphthalen-1-yl)-N,N'-bis-(phenyl)benzidine (NPB); 4,4',4"-tris(N-carbazolyl)triphenylamine (TCTA); 4,4'-bis(N-carbazolyl)-1,1'-biphenyl (CBP), 1,3-di-(9-carbazolyl)benzene (mCP); and 4,4',4"-tris[(3-methylphenyl)phenylamino]triphenylamine (m-TDATA).

### c. Dopant Materials

Electroluminescent materials include small molecule organic fluorescent compounds, fluorescent and phosphorescent metal complexes, conjugated polymers, and mixtures thereof. Examples of fluorescent compounds include, but are not limited to, chrysenes, pyrenes, perylenes, rubrenes, coumarins, anthracenes, thiadiazoles, derivatives thereof, and mixtures thereof. Examples of metal complexes include, but are not limited to, metal chelated oxinoid compounds, such as tris(8-hydroxyquinolato)aluminum (AIQ); cyclometalated iridium and platinum electroluminescent compounds, such as complexes of iridium with phenylpyridine, phenylquinoline, or phenylpyrimidine ligands as disclosed in Petrov et al., U.S. Patent 6,670,645 and Published PCT Applications WO 03/063555 and WO 2004/016710, and organometallic complexes described in, for example, Published PCT Applications WO 03/008424, WO 03/091688, and WO 03/040257, and mixtures thereof.

In some embodiments, the photoactive dopant is a cyclometalated complex of iridium. In some embodiments, the complex has two ligands selected from phenylpyridines, phenylquinolines, and phenylisoquinolines, and a third liqand which is a β-dienolate. The ligands may be unsubstituted or substituted with F, D, alkyl, perfluororalkyl, alkoxyl, alkylamino, arylamino, CN, silyl, fluoroalkoxyl or aryl groups.

In some embodiments, separate photoactive compositions with different dopants are used to provide different colors. In some embodiments, the dopants are selected to have red, green, and blue emission. As used herein, red refers to light having a wavelength maximum in the range of 600-700 nm; green refers to light having a wavelength maximum in the range of 500-600 nm; and blue refers to light having a wavelength maximum in the range of 400-500 nm.

Examples of blue light-emitting materials include, but are not limited to, diarylanthracenes, diaminochrysenes, diaminopyrenes, cyclometalated complexes of Ir having phenylpyridine ligands, and polyfluorene polymers. Blue light-emitting materials have been disclosed in, for example, US patent 6,875,524, and published US applications 2007-0292713 and 2007-0063638.

Examples of red light-emitting materials include, but are not limited to, cyclometalated complexes of Ir having phenylquinoline or phenylisoquinoline ligands, periflanthenes, fluoranthenes, and perylenes. Red light-emitting materials have been disclosed in, for example, US patent 6,875,524, and published US application 2005-0158577.

Examples of green light-emitting materials include, but are not limited to, cyclometalated complexes of Ir having phenylpyridine ligands, diaminoanthracenes, and polyphenylenevinylene polymers. Green light-emitting materials have been disclosed in, for example, published PCT application WO 2007/021117.

Examples of dopant materials include, but are not limited to, compounds C1 to C10 below.

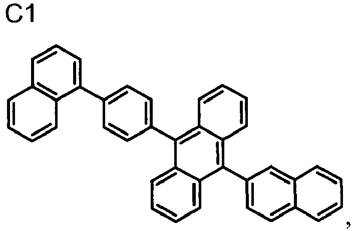

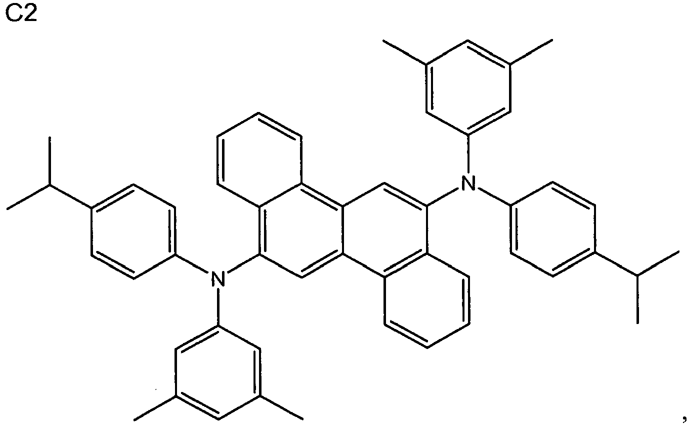

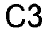

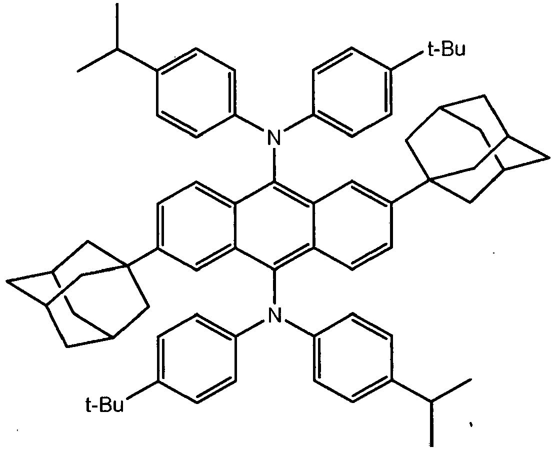

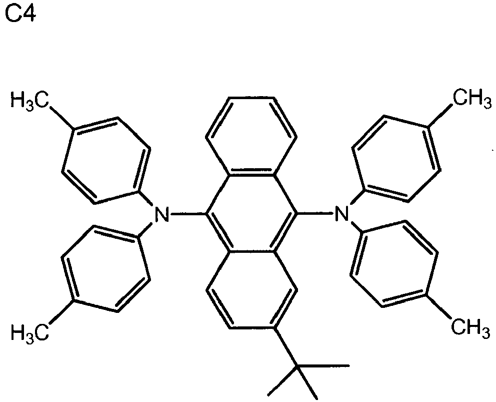

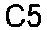

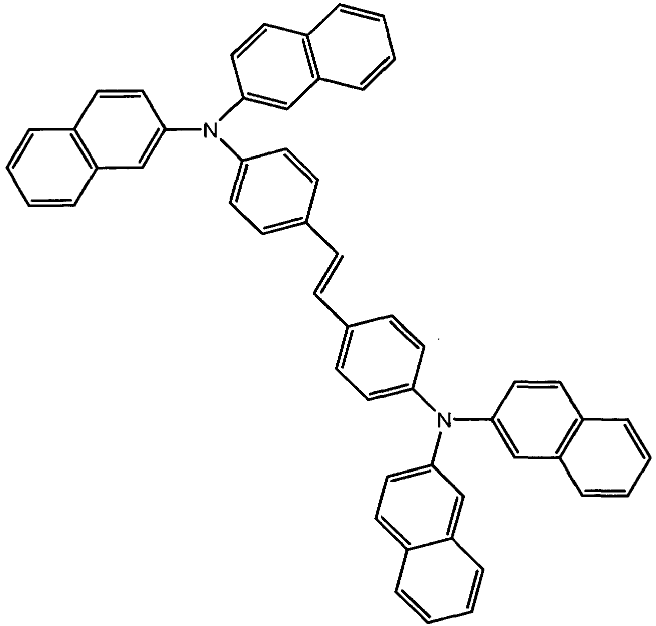

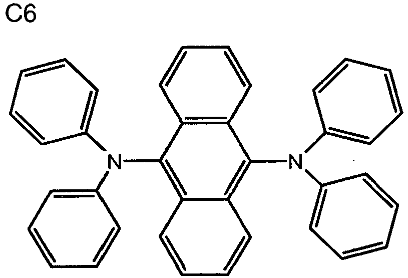

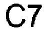

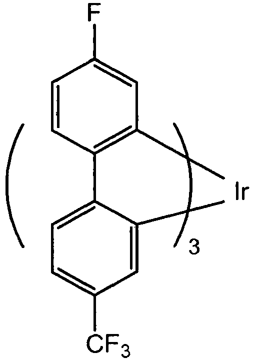

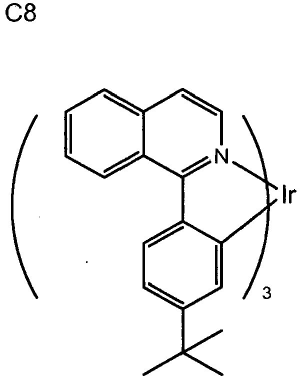

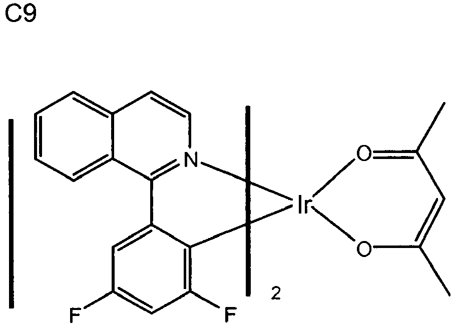

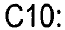

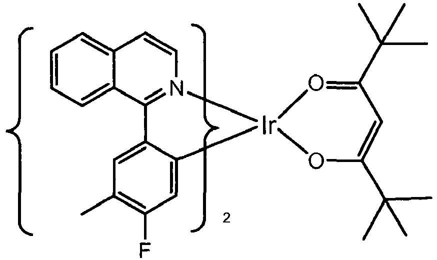

### 3. Electronic Device

Organic electronic devices that may benefit from having the photoactive composition described herein include, but are not limited to, (1) devices that convert electrical energy into radiation (e.g., a light-emitting diode, light emitting diode display, or diode laser), (2) devices that detect signals through electronics processes (e.g., photodetectors, photoconductive cells, photoresistors, photoswitches, phototransistors, phototubes, IR detectors, biosensors), (3) devices that convert radiation into electrical energy, (e.g., a photovoltaic device or solar cell), and (4) devices that include one or more electronic components that include one or more organic semi-conductor layers (e.g., a transistor or diode).

In some embodiments, an organic light-emitting device comprises:
an anode;
a hole transport layer;
a photoactive layer;
an electron transport layer, and
a cathode;
wherein the photoactive layer comprises the composition described above.

One illustration of an organic electronic device structure is shown in Figure 1. The device 100 has a first electrical contact layer, an anode layer 110 and a second electrical contact layer, a cathode layer 160, and a photoactive layer 140 between them. Adjacent to the anode is a buffer layer 120. Adjacent to the buffer layer is a hole transport layer 130, comprising hole transport material. Adjacent to the cathode may be an electron transport layer 150, comprising an electron transport material. As an option, devices may use one or more additional hole injection or hole transport layers (not shown) next to the anode 110 and/or one or more additional electron injection or electron transport layers (not shown) next to the cathode 160.

Layers 120 through 150 are individually and collectively referred to as the active layers.

In one embodiment, the different layers have the following range of thicknesses: anode 110, 500-5000 Å, in one embodiment 1000-2000 Å; buffer layer 120, 50-2000 Å, in one embodiment 200-1000 Å; hole transport layer 130, 50-2000 Å, in one embodiment 200-1000 Å; photoactive layer 140, 10-2000 Å, in one embodiment 100-1000 Å; layer 150, 50-2000 Å, in one embodiment 100-1000 Å; cathode 160, 200-10000 Å, in one embodiment 300-5000 Å. The location of the electron-hole recombination zone in the device, and thus the emission spectrum of the device, can be affected by the relative thickness of each layer. The desired ratio of layer thicknesses will depend on the exact nature of the materials used.

Depending upon the application of the device 100, the photoactive layer 140 can be a light-emitting layer that is activated by an applied voltage (such as in a light-emitting diode or light-emitting electrochemical cell), or a layer of material that responds to radiant energy and generates a signal with or without an applied bias voltage (such as in a photodetector). Examples of photodetectors include photoconductive cells, photoresistors, photoswitches, phototransistors, and phototubes, and photovoltaic cells, as these terms are described in Markus, John, Electronics and Nucleonics Dictionary, 470 and 476 (McGraw-Hill, Inc. 1966).

### a. Photoactive layer

The photoactive layer comprises the photoactive composition described above.

The photoactive layer can be formed by liquid deposition from a liquid composition, as described below. In some embodiments, the photoactive layer is formed by vapor deposition.

In some embodiments, three different photoactive compositions are applied to form red, green, and blue subpixels. In some embodiments, each of the colored subpixels is formed using new photoactive compositions as described herein. In some embodiments, the first and second host materials are the same for all of the colors.

### b. Other Device Layers

The other layers in the device can be made of any materials that are known to be useful in such layers.

The anode 110, is an electrode that is particularly efficient for injecting positive charge carriers. It can be made of, for example, materials containing a metal, mixed metal, alloy, metal oxide or mixed-metal oxide, or it can be a conducting polymer, or mixtures thereof. Suitable metals include the Group 11 metals, the metals in Groups 4-6, and the Group 8-10 transition metals. If the anode is to be light-transmitting, mixed-metal oxides of Groups 12, 13 and 14 metals, such as indium-tin-oxide, are generally used. The anode 110 can also comprise an organic material such as polyaniline as described in "Flexible light-emitting diodes made from soluble conducting polymer," Nature vol. 357, pp 477-479 (11 June 1992). At least one of the anode and cathode is desirably at least partially transparent to allow the generated light to be observed.

The buffer layer 120 comprises buffer material and may have one or more functions in an organic electronic device, including but not limited to, planarization of the underlying layer, charge transport and/or charge injection properties, scavenging of impurities such as oxygen or metal ions, and other aspects to facilitate or to improve the performance of the organic electronic device. Buffer materials may be polymers, oligomers, or small molecules. They may be vapour deposited or deposited from liquids which may be in the form of solutions, dispersions, suspensions, emulsions, colloidal mixtures, or other compositions.

The buffer layer can be formed with polymeric materials, such as polyaniline (PANI) or polyethylenedioxythiophene (PEDOT), which are often doped with protonic acids. The protonic acids can be, for example, poly(styrenesulfonic acid), poly(2-acrylamido-2-methyl-1-propanesulfonic acid), and the like.

The buffer layer can comprise charge transfer compounds, and the like, such as copper phthalocyanine and the tetrathiafulvalene-tetracyanoquinodimethane system (TTF-TCNQ).

In some embodiments, the buffer layer comprises at least one electrically conductive polymer and at least one fluorinated acid polymer. Such materials have been described in, for example, published U.S. patent applications 2004-0102577, 2004-0127637, and 2005/205860

Examples of hole transport materials for layer 130 have been summarized for example, in Kirk-Othmer Encyclopedia of Chemical Technology, Fourth Edition, Vol. 18, p. 837-860, 1996, by Y. Wang. Both hole transporting molecules and polymers can be used. Commonly used hole transporting molecules are: N,N'-diphenyl-N,N'-bis(3-methylphenyl)-[1,1'-biphenyl]-4,4'-diamine (TPD), 1,1-bis[(di-4-tolylamino) phenyl]cyclohexane (TAPC), N,N'-bis(4-methylphenyl)-N,N'-bis(4-ethylphenyl)-[1,1'-(3,3'-dimethyl)biphenyl]-4,4'-diamine (ETPD), tetrakis-(3-methylphenyl)-N,N,N',N'-2,5-phenylenediamine (PDA), a-phenyl-4-N,N-diphenylaminostyrene (TPS), p-(diethylamino)benzaldehyde diphenylhydrazone (DEH), triphenylamine (TPA), bis[4-(N,N-diethylamino)-2-methylphenyl](4-methylphenyl)methane (MPMP), 1-phenyl-3-[p-(diethylamino)styryl]-5-[p-(diethylamino)phenyl] pyrazoline (PPR or DEASP), 1,2-trans-bis(9H-carbazol-9-yl)cyclobutane (DCZB), N,N,N',N'-tetrakis(4-methylphenyl)-(1,1'-biphenyl)-4,4'-diamine (TTB), N,N'-bis(naphthalen-1-yl)-N,N'-bis-(phenyl)benzidine (α-NPB), and porphyrinic compounds, such as copper phthalocyanine. Commonly used hole transporting polymers are polyvinylcarbazole, (phenylmethyl)-polysilane, and polyaniline. It is also possible to obtain hole transporting polymers by doping hole transporting molecules such as those mentioned above into polymers such as polystyrene and polycarbonate. In some cases, triarylamine polymers are used, especially triarylamine-fluorene copolymers. In some cases, the polymers and copolymers are crosslinkable. In some embodiments, the hole transport layer further comprises a p-dopant. In some embodiments, the hole transport layer is doped with a p-dopant. Examples of p-dopants include, but are not limited to, tetrafluorotetracyanoquinodimethane (F4-TCNQ) and perylene-3,4,9,10-tetracarboxylic-3,4,9,10-dianhydride (PTCDA).

Examples of electron transport materials which can be used for layer 150 include, but are not limited to, metal chelated oxinoid compounds, including metal quinolate derivatives such as tris(8-hydroxyquinolato)aluminum (AlQ), bis(2-methyl-8-quinolinolato)(p-phenylphenolato) aluminum (BAlq), tetrakis-(8-hydroxyquinolato)hafnium (HfQ) and tetrakis-(8-hydroxyquinolato)zirconium (ZrQ); and azole compounds such as 2- (4-biphenylyl)-5-(4-t-butylphenyl)-1,3,4-oxadiazole (PBD), 3-(4-biphenylyl)-4-phenyl-5-(4-t-butylphenyl)-1,2,4-triazole (TAZ), and 1,3,5-tri(phenyl-2-benzimidazole)benzene (TPBI); quinoxaline derivatives such as 2,3-bis(4-fluorophenyl)quinoxaline; phenanthrolines such as 4,7-diphenyl-1,10-phenanthroline (DPA) and 2,9-dimethyl-4,7-diphenyl-1,10-phenanthroline (DDPA); and mixtures thereof. In some embodiments, the electron transport layer further comprises an n-dopant. Examples of n-dopants include, but are not limited to Cs and other alkali metals,

The cathode 160, is an electrode that is particularly efficient for injecting electrons or negative charge carriers. The cathode can be any metal or nonmetal having a lower work function than the anode. Materials for the cathode can be selected from alkali metals of Group 1 (e.g., Li, Cs), the Group 2 (alkaline earth) metals, the Group 12 metals, including the rare earth elements and lanthanides, and the actinides. Materials such as aluminum, indium, calcium, barium, samarium and magnesium, as well as combinations, can be used. Li-containing organometallic compounds, LiF, Li₂O, Cs-containing organometallic compounds, CsF, Cs₂O and Cs₂CO₃ can also be deposited as an electron injection layer between the organic layer and the cathode layer to lower the operating voltage.

It is known to have other layers in organic electronic devices. For example, there can be a layer (not shown) between the anode 110 and buffer layer 120 to control the amount of positive charge injected and/or to provide band-gap matching of the layers, or to function as a protective layer. Layers that are known in the art can be used, such as copper phthalocyanine, silicon oxy-nitride, fluorocarbons, silanes, or an ultra-thin layer of a metal, such as Pt. Alternatively, some or all of anode layer 110, active layers 120, 130, 140, and 150, or cathode layer 160, can be surface-treated to increase charge carrier transport efficiency. The choice of materials for each of the component layers is preferably determined by balancing the positive and negative charges in the emitter layer to provide a device with high electroluminescence efficiency.

It is understood that each functional layer can be made up of more than one layer.

### c. Device Fabrication

The device layers can be formed by any deposition technique, or combinations of techniques, including vapor deposition, liquid deposition, and thermal transfer. Substrates such as glass, plastics, and metals can be used. Conventional vapor deposition techniques can be used, such as thermal evaporation, chemical vapor deposition, and the like. The organic layers can be applied from solutions or dispersions in suitable solvents, using conventional coating or printing techniques, including but not limited to spin-coating, dip-coating, roll-to-roll techniques, ink-jet printing, continuous nozzle printing, screen-printing, gravure printing and the like.

In some embodiments, the device is fabricated by liquid deposition of the buffer layer, the hole transport layer, and the photoactive layer, and by vapor deposition of the anode, the electron transport layer, an electron injection layer and the cathode.

### EXAMPLES

The concepts described herein will be further described in the following examples, which do not limit the scope of the invention described in the claims.

### Example 1

This example illustrates the preparation of phenanthroline derivative A2, using Suzuki coupling of 2,9-dichloro-4,7- diphenyl1,10-phenanthroline. Example 2A below gives the details of the preparation of this intermediate.with the boronic ester shown below. 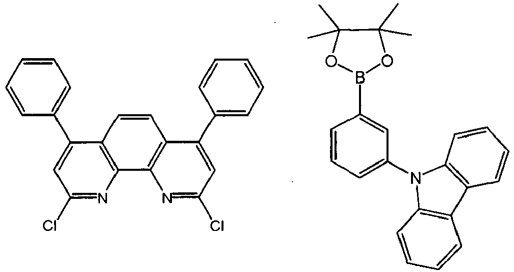 Take 2.0g of dichloro-phen (5mM) in glove box and add 4.0g (11mM) boronic ester. Add 0.15g Pd2DBA3 (0.15mM), 0.1 g tricyclohexylphosphine (0.35mM) and 3.75g potassium phosphate (17mM) and dissolve all into 30mL dioxane and 15mL water. Mix and heat in glove box in mantle at 110C for 1hr then warm gently (minimum rheostat setting) under nitrogen overnight. Solution immediately is dark purple but on reaching ∼80C it is a tan brown slurry which slowly becomes clear brown with a dense ppt. As the solution refluxes (air condensor) a flocculent ppt forms. Cool and work up by removing from glove box and filter off white fibers from the dioxane after adding more water. Dissolve into chloroform and then evaporate and ppt in toluene by adding methanol as off white fine needles. Collect by filtration and wash well with methanol to isolate ∼3.55g material. The structure was confirmed by NMR analysis as Compound A2: 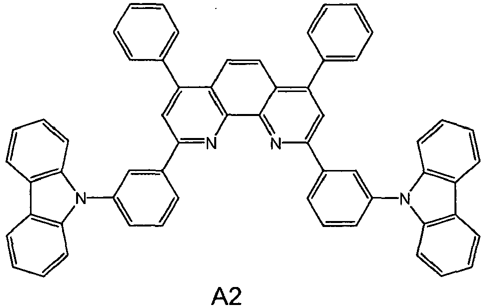 The properties of compound A2 were as follows:
Tg = 172°C
photoluminescence peak (2% in toluene) = 406 nm
UV/Vis peaks = 341, 293 nm
electroluminescent emissive peak = 405 nm

### Example 2

This example illustrates the preparation of first host material A3, using Suzuki coupling of 2,9-dichloro-4,7-diphenyl-1,10-phenanthroline with 4-triphenylaminoboronic acid.

### Part A: preparation of an intermediate dichlorobathophenanthroline compound, 2,9-dichloro-4,7-diphenyl-1,10-phenanthroline.

a) The procedure from Yamada et al Bull Chem Soc Jpn, 63, 2710, 1990 was used to prepare the trimethylene bridged bathophenanthroline as follows: 2g of bathophenanthroline was taken into 20g 1,3-dibromopropane and refluxed under air. After about 30mins the dense orange slurry was cooled. Methanol was added to dissolve the solids, and then acetone was added to precipitate a bright orange solid. This was filtered and washed with toluene and dichloromethane resulting in an orange powder in 2.8g yield. 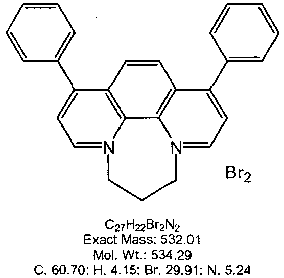
b) 2.8g of product from above was dissolved into 12mL water and dripped into an ice-cooled solution of 21g potassium ferricyanide and 10g sodium hydroxide in 30mL water over the course of about 30mins, and then stirred for 90mins. This was iced again and neutralized with 60mL of 4M HCl to a pH of about 8. The pale tan/yellow solid was filtered off and suctioned dry. The filtered solid was placed in a soxhlet and extracted with chloroform to extract a brown solution. This was evaporated to a brownish oily solid and then washed with a small amount of methanol to give a pale brown solid (∼1.0g 47%). The material can be recrystallized from chloroform/methanol as golden platelets by evaporating out the chloroform from the mixture. The structure was identified by NMR as the diketone below. 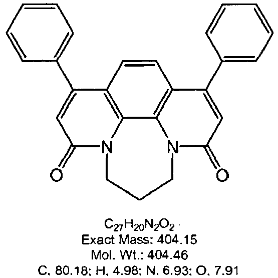
c) Combined portions of diketone from step (b) above totaling 5.5g (13.6mM) were suspended in 39mL POCl₃ and 5.4g PCl₅ was added. This was degassed and refluxed under nitrogen for 8hrs. The excess POCl3 was removed by evaporation. Ice was added to decompose the remaining chlorides and the mixture was neutralized with ammonia. The brown precipitate was collected and dried under vacuum while the mother liquor was extracted with methylene chloride. All brown material was combined, evaporated to a brown gum and methanol added. After shaking and stirring a pale yellow solid was isolated which recrystallized as off-white needles from CHCl3 and methanol (1:10). Analysis by NMR indicated the dichlorobathophenanthroline structure below.

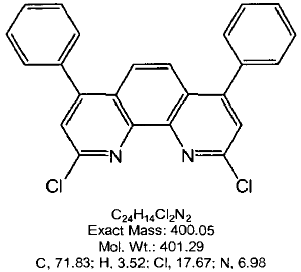

### Part B: preparation of second host material A3

To 2.0g of dichlorobathophenanthroline (5mM) from Part A was added 3.0g (11 mM) p-diphenylaminophenylboronic acid. To this was added 0.15g Pd2DBA3 (0.15mM), 0.1 g tricyclohexylphosphine (0.35mM) and 3.75g potassium phosphate (17mM), and all were dissolved into 30mL dioxane and 15mL water. This was mixed and heated in a glove box at 100°C for 1 hr, then warmed gently (minimum rheostat setting) under nitrogen overnight. On reaching about 80°C the mixture was a tan brown slurry which slowly became clear brown with a dense precipitate. As the solution refluxed (air condensor) a white powdery precipitate formed. The mixture was cooled and removed from the glove box. The dioxane was removed by evaporation and additional water added. A light brown gummy solid was isolated by filtration and washed with water. The solid dissolved well in toluene and dichloromethane. The product was compound A3.

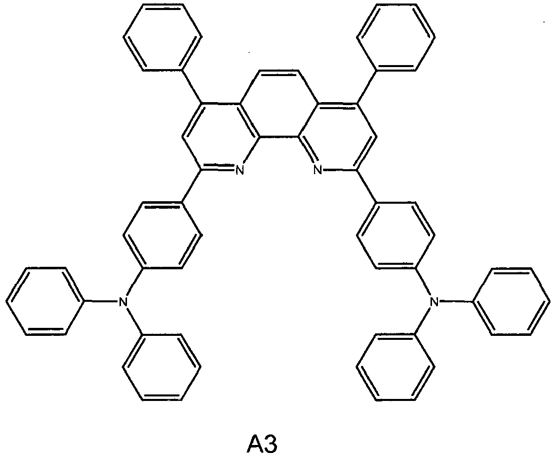

### Example 3

Second host compound A1 was prepared using Suzuki coupling of 2,9-dichloro-4,7-diphenyl-1,10-phenanthroline with phenylboronic acid, using a procedure similar to Example 2.

### Example 4

Dopant material C10 was prepared using a procedure similar to that described in US Patent 6,670,645.

### Example 5

This example demonstrates the fabrication and performance of OLED devices. The following materials were used:
anode = Indium Tin Oxide (ITO): 180 nm
buffer layer = Buffer 1 (70 nm), which is an aqueous dispersion of an electrically conductive polymer and a polymeric fluorinated sulfonic acid. Such materials have been described in, for example, published U.S. patent applications US 2004/0102577, US 2004/0127637, and US 2005/0205860.
hole transport layer = NPB (30 nm)
photoactive layer = 12.5:1 host:dopant C10, as shown in Table 1 (43 nm)
electron transport layer = a metal quinolate derivative (30 nm) electron injection layer (EIL) = as shown in Table 1
cathode = Al (0.5/100 nm)
The buffer material was applied by spin-coating. The other layers were applied by vapor deposition.

The device structure is summarized in Table 1. The results are summarized in Table 2 below.

**Table 1. Device structure**

| Example | Host | EIL |
|---|---|---|
| Comparative A | NPB | LiF (1 nm) |
| Comparative B | A1 | LiF (1 nm) |
| Example 5-1 | A1 + NPB (8:2) | LiF (1 nm) |
| Comparative C | NPB | CsF (1.5 nm) |
| Comparative D | A2 | CsF (1.5 nm) |
| Example 5-2 | A2 + NPB (8:2) | CsF (1.5 nm) |

**Table 2. Device results**

| Example | Voltage, V | CE (cd/A) | EQE (%) | Color (x,y) |
|---|---|---|---|---|
| Comparative A | 7.8 | 1.2 | 0.73 | (0.59, 0.399) |
| Comparative B | 6.8 | 14.7 | 19.3 | (0.67, 0.33) |
| Example 5-1 | 5.6 | 22.5 | 19.5 | (0.66, 0.34) |
| Comparative C | 5.8 | 1.63 | 1.07 | (0.6, 0.38) |
| Comparative D | 6.9 | 4.6 | 4.0 | (0.65, 0.35) |
| Example.5-2 | 4.1 | 20.7 | 17.8 | (0.66, 0.34) |

| | | | | |
|---|---|---|---|---|
| CE = current efficiency; EQE = external quantum efficiency; x and y are the color coordinates according to the C.I.E. chromaticity scale (Commission Internationale de L'Eclairage, 1931). | | | | |

As can be seen from the above data, the devices with the photoactive composition described herein have much higher efficiencies.

Note that not all of the activities described above in the general description or the examples are required, that a portion of a specific activity may not be required, and that one or more further activities may be performed in addition to those described. Still further, the order in which activities are listed are not necessarily the order in which they are performed.

It is to be appreciated that certain features are, for clarity, described herein in the context of separate embodiments, may also be provided in combination in a single embodiment. Conversely, various features that are, for brevity, described in the context of a single embodiment, may also be provided separately or in any subcombination. Further, reference to values stated in ranges include each and every value within that range.

## Claims

1. A photoactive composition comprising: (a) a first host material comprising a phenanthroline derivative; (b) a second host material comprising an aromatic amine having a HOMO level of -5.4 eV ± 0.2 eV; and (c) an electroluminescent dopant material; wherein the weight ratio of first host material to second host material is in the range of 99:1 to 50:50,
**characterised in that**
the first host has Formula I: 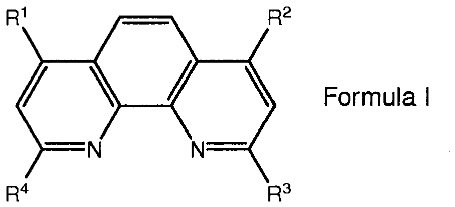 wherein R¹ to R⁴ are independently selected from the group consisting of naphthyl, naphthylphenyl, phenylnaphthyl, carbazolyl, carbozolylphenyl, triphenylamino, arylanthracenyl, and a group having Formula II: 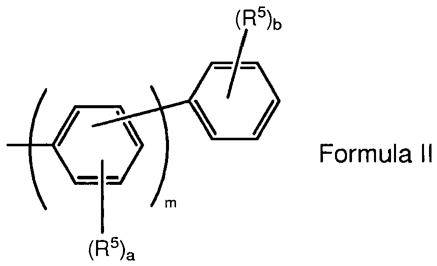 where:
R⁵ is the same or different at each occurrence and is selected from the group consisting of D, alkyl, alkoxy, and aryl;
a is the same or different at each occurrence and is an integer from 0-4;
b is the same or different at each occurrence and is an integer from 0-5; and
m is the same or different at each occurrence and is an integer from 0 to 6.

2. The photoactive composition of Claim 1, wherein the aromatic amine is selected from the group consisting of N,N'-diphenyl-N,N'-bis(3-methylphenyl)-[1,1'-biphenyl]-4,4'-diamine (TPD), 1,1 -bis[(di-4-tolylamino) phenyl]cyclohexane (TAPC), and N,N'-bis(naphthalen-1-yl)-N,N'-bis-(phenyl)benzidine (NPB).

3. The composition of Claim 1, wherein the dopant is a phosphorescent material.

4. The composition of Claim 3, wherein the dopant material is a cyclometalated complex of Ir.

5. An organic light-emitting device comprising:
an anode;
a hole transport layer;
a photoactive layer comprising the photoactive composition of claim 1;
an electron transport layer; and
a cathode.

6. The device of Claim 5, wherein in the photo active composition R¹ to R⁴ are independently selected from the group consisting of phenyl, biphenyl, terphenyl, quaterphenyl, naphthyl, phenanthryl, naphthylphenyl, phenanthrylphenyl, carbazolyl, and carbazolylphenyl.

7. The device of Claim 5, wherein in the photoactive composition the aromatic amine is selected from the group consisting of N,N'-diphenyl-N,N'-bis(3-methylphenyl)-[1,1'-biphenyl]-4,4'-diamine (TPD), 1,1-bis[(di-4-tolylamino) phenyl]cyclohexane (TAPC), and N,N'-bis(naphthalen-1-yl)-N,N'-bis-(phenyl)benzidine (NPB).

8. The device of Claim 5, wherein the dopant is a phosphorescent material.

9. The device of Claim 8, wherein the dopant material is a cyclometalated complex of Ir.

10. The photoactive composition of claim 1 wherein the first host has Formula I and R¹ to R⁴ are independently selected from the group consisting of naphthyl, naphthylphenyl, phenylnaphthyl, carbazolyl, triphenylamino, arylanthracenyl and a group having Formula II.

11. The photoactive composition of any one of claims 1-4 and 10 wherein the weight ratio of first host material to second host material is in the range of 90:10 to 70:30.

12. The photoactive composition of claim 1 wherein the first host is selected from

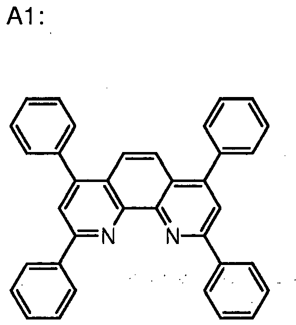

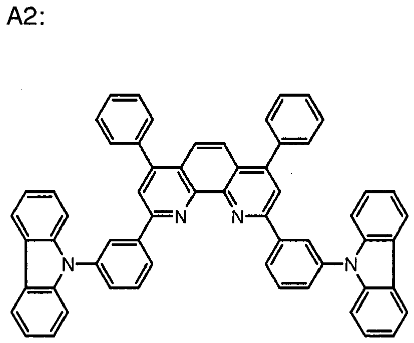

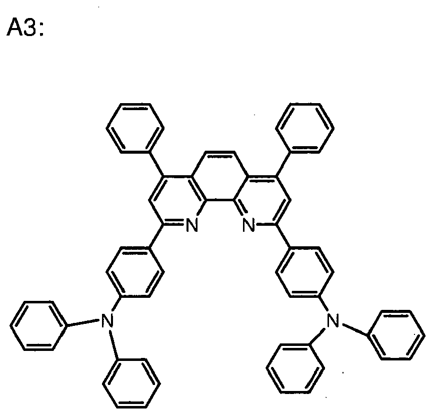

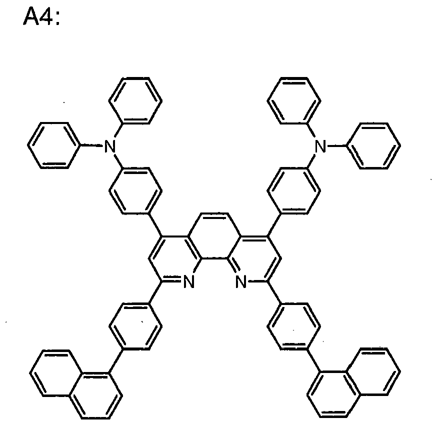

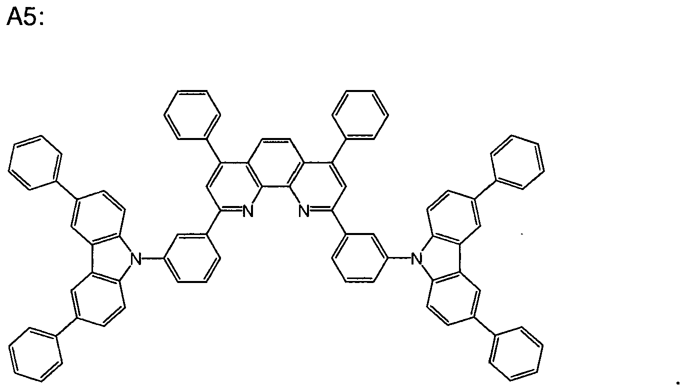

13. The organic light-emitting device of claim 5 wherein in the photoactive composition the first host has Formula I and R¹ to R⁴ are independently selected from the group consisting of naphthyl, naphthylphenyl, phenylnaphthyl, carbazolyl, triphenylamino, arylanthracenyl and a group having Formula II.

14. The organic light-emitting device of any one of claims 5-9 and 13 wherein in the photoactive composition the weight ratio of first host material to second host material is in the range of 90:10 to 70:30.

15. The organic light-emitting device of claim 5 wherein in the photoactive composition the first host is selected from

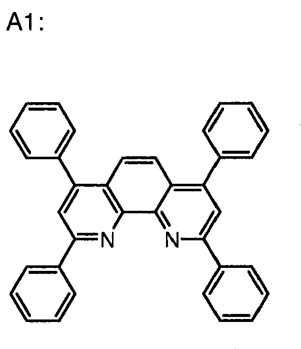

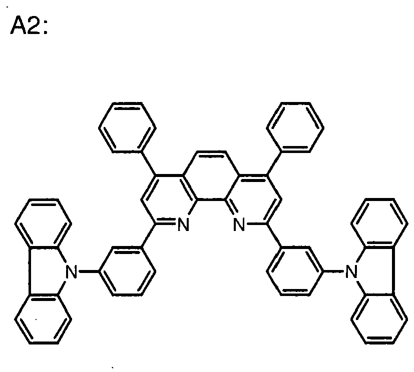

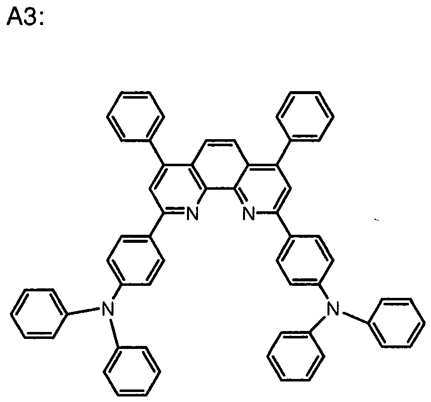

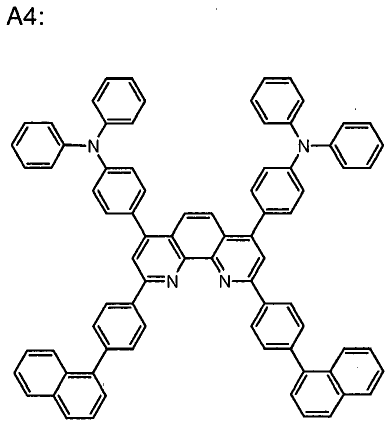

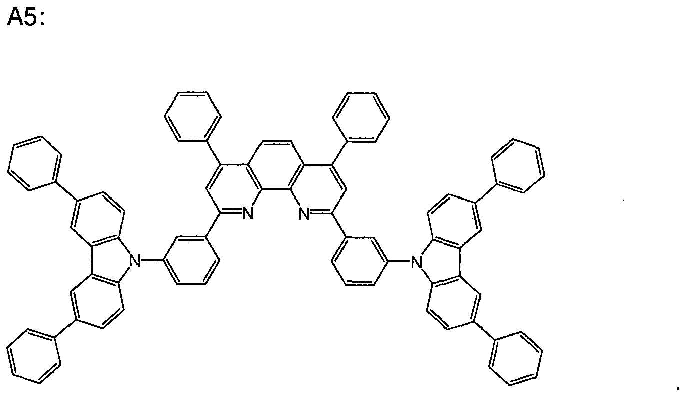

## Patentansprüche

1. Fotoaktive Zusammensetzung umfassend: (a) ein erstes Wirtsmaterial umfassend ein Phenanthrolinderivat; (b) ein zweites Wirtsmaterial umfassend ein aromatisches Amin, das ein HOMO-Niveau von -5,4 eV ± 0,2 eV aufweist; und (c) ein elektrolumineszierendes Dotiermaterial; wobei das Gewichtsverhältnis des ersten Wirtsmaterials zum zweiten Wirtsmaterial im Bereich von 99:1 bis 50:50 liegt,
**dadurch gekennzeichnet, dass**
der erste Wirt die Formel I aufweist: 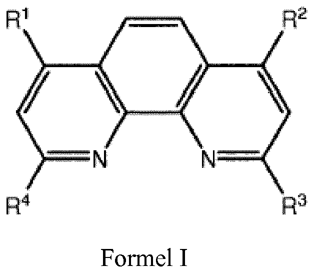 wobei R¹ bis R⁴ unabhängig aus der Gruppe bestehend aus Naphthyl, Naphthylphenyl, Phenylnaphthyl, Carbazolyl, Carbazolylphenyl, Triphenylamino, Arylanthracenyl und einer Gruppe ausgewählt sind, die die Formel II aufweist: 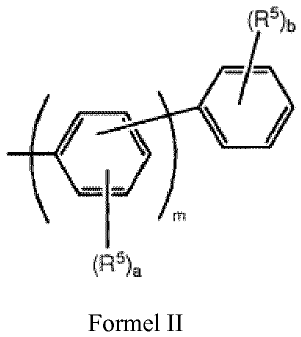 wobei:
R⁵ bei jedem Vorkommen gleich oder anders und aus der Gruppe ausgewählt ist bestehend aus D, Alkyl, Alkoxy und Aryl;
a bei jedem Vorkommen gleich oder anders und eine ganze Zahl von 0 - 4 ist;
b bei jedem Vorkommen gleich oder anders und eine ganze Zahl von 0 - 5 ist; und
m bei jedem Vorkommen gleich oder anders und eine ganze Zahl von 0 bis 6 ist.

2. Fotoaktive Zusammensetzung nach Anspruch 1, wobei das aromatische Amin aus der Gruppe ausgewählt ist bestehend aus N,N'-Diphenyl-N,N'-bis(3-methylphenyl)-[1,1'-biphenyl]-4,4'-diamin (TPD), 1,1-Bis[(di-4-tolylamino)phenyl]cyclohexan (TAPC) und N,N'-Bis(naphthalin-1-yl)-N,N'-bis(phenyl)benzidin (NPB).

3. Zusammensetzung nach Anspruch 1, wobei das Dotiermittel ein phosphoreszierendes Material ist.

4. Zusammensetzung nach Anspruch 3, wobei das Dotiermaterial ein cyclometallierter Komplex von Ir ist.

5. Organische lichtemittierende Vorrichtung umfassend:
eine Anode;
eine Lochtransportschicht,
eine fotoaktive Schicht, die die fotoaktive Zusammensetzung nach Anspruch 1 umfasst;
eine Elektronentransportschicht; und
eine Kathode.

6. Vorrichtung nach Anspruch 5, wobei in der fotoaktiven Zusammensetzung R¹ bis R⁴ unabhängig aus der Gruppe ausgewählt sind bestehend aus Phenyl, Biphenyl, Terphenyl, Quaterphenyl, Naphthyl, Phenanthryl, Naphthylphenyl, Phenanthrylphenyl, Carbazolyl und Carbazolylphenyl.

7. Vorrichtung nach Anspruch 5, wobei, in der fotoaktiven Zusammensetzung, das aromatische Amin aus der Gruppe ausgewählt ist bestehend aus N,N'-Diphenyl-N,N'-bis(3-methylphenyl)-[1,1-biphenyl]-4,4'-diamin (TPD), 1,1-Bis[(di-4-tolylamino)phenyl]cyclohexan (TAPC) und N,N'-Bis(naphthalin-1-yl)-N,N'-bis(phenyl)benzidin (NPB).

8. Vorrichtung nach Anspruch 5, wobei das Dotiermittel ein phosphoreszierendes Material ist.

9. Vorrichtung nach Anspruch 8, wobei das Dotiermaterial ein cyclometallierter Komplex von Ir ist.

10. Fotoaktive Zusammensetzung nach Anspruch 1, wobei der erste Wirt die Formel I aufweist und R¹ bis R⁴ unabhängig aus der Gruppe ausgewählt sind bestehend aus Naphthyl, Naphthylphenyl, Phenylnaphthyl, Carbazolyl, Triphenylamino, Arylanthracenyl und einer Gruppe, die die Formel II aufweist.

11. Fotoaktive Zusammensetzung nach einem der Ansprüche 1 - 4 und 10, wobei das Gewichtsverhältnis des ersten Wirtsmaterials zum zweiten Wirtsmaterial im Bereich von 90:10 bis 70:30 liegt.

12. Fotoaktive Zusammensetzung nach Anspruch 1, wobei der erste Wirt ausgewählt ist von

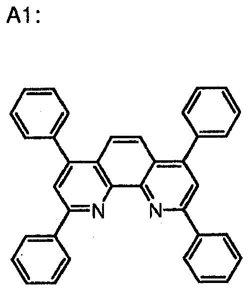

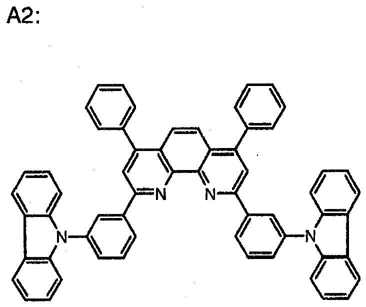

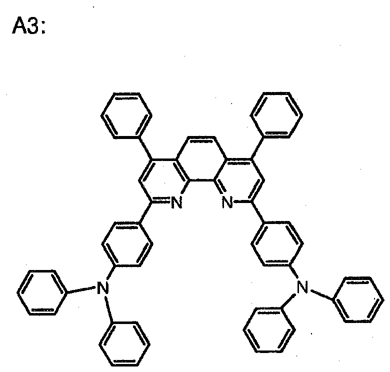

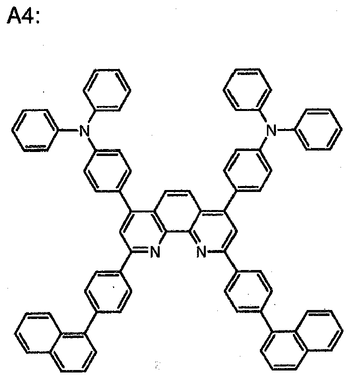

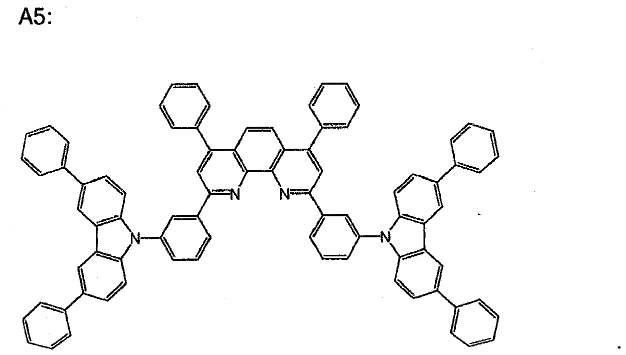

13. Organische lichtemittierende Vorrichtung nach Anspruch 5, wobei, in der fotoaktiven Zusammensetzung, der erste Wirt die Formel I aufweist und R¹ bis R⁴ unabhängig aus der Gruppe ausgewählt sind bestehend aus Naphthyl, Naphthylphenyl, Phenylnaphthyl, Carbazolyl, Triphenylamino, Arylanthracenyl und einer Gruppe, die die Formel II aufweist.

14. Organische lichtemittierende Vorrichtung nach einem der Ansprüche 5 - 9 und 13, wobei, in der fotoaktiven Zusammensetzung, das Gewichtsverhältnis des ersten Wirtsmaterials zum zweiten Wirtsmaterial im Bereich von 90:10 bis 70:30 liegt.

15. Organische lichtemittierende Vorrichtung nach Anspruch 5, wobei, in der fotoaktiven Zusammensetzung, der erste Wirt ausgewählt ist von

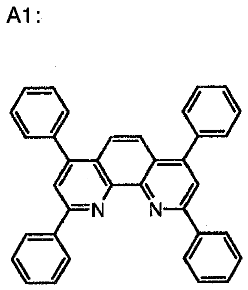

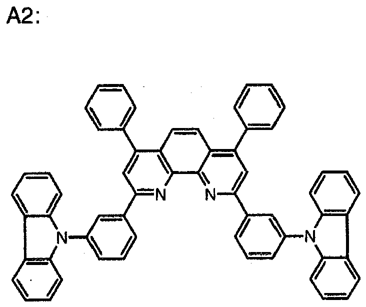

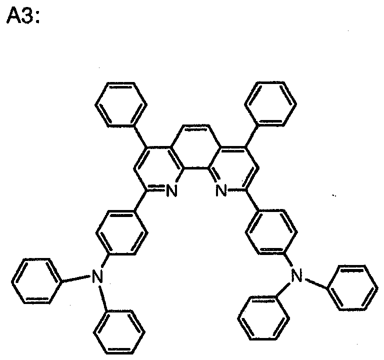

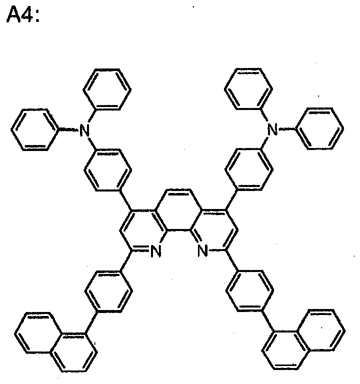

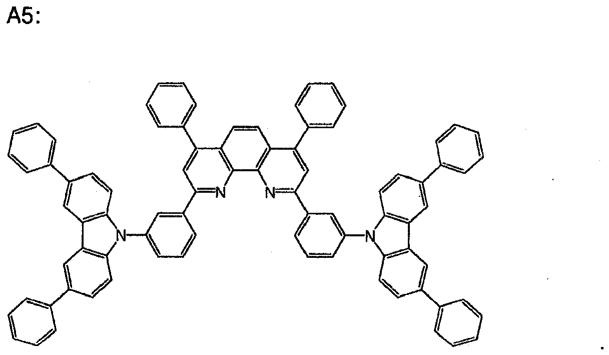

## Revendications

1. Composition photoactive comprenant: (a) une première matière hôte comprenant un dérivé de phénanthroline; (b) une seconde matière hôte comprenant une amine aromatique ayant un niveau HOMO de -5,4eV ± 0,2eV; et (c) une matière dopante électroluminescente; dans laquelle le rapport pondéral de la première matière hôte à la seconde matière hôte est dans la gamme de 99:1 à 50:50,
**caractérisée en ce que**
le premier hôte a la formule I: 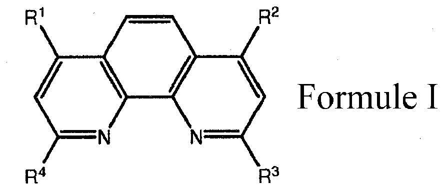 dans laquelle R¹ à R⁴ sont indépendamment choisis dans le groupe constitué par naphtyle, naphtylphényle, phénylnaphtyle, carbazolyle, carbozolylphényle, triphénylamino, arylanthracényle, et un groupe ayant la formule II: 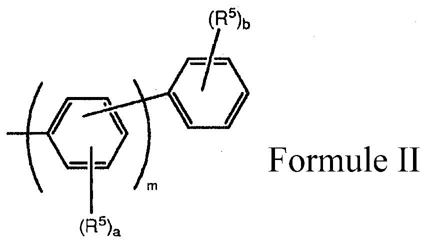 dans laquelle:
R⁵ est identique ou différent à chaque occurrence et est choisi dans le groupe constitué par D, alkyle, alcoxy et aryle;
a est identique ou différent à chaque occurrence et est un entier de 0 à 4;
b est identique ou différent à chaque occurrence et est un entier de 0 à 5; et
m est identique ou différent à chaque occurrence et est un entier de 0 à 6.

2. Composition photoactive selon la revendication 1, dans laquelle l'amine aromatique est choisie dans le groupe constitué par la N,N'-diphényl-N,N'-bis(3-méthylphényl)-[1,1'-biphényl]-4,4'-diamine (TPD), le 1,1-bis[(di-4-tolylamino)phényl]cyclohexane (TAPC) et la N,N'-bis(naphtalén-1-yl)-N,N'-bis-(phényl)benzidine (NPB).

3. Composition selon la revendication 1, dans laquelle le dopant est une matière phosphorescente.

4. Composition selon la revendication 3, dans laquelle la matière dopante est un complexe cyclométallé de Ir.

5. Dispositif luminescent organique comprenant:
une anode;
une couche de transport de trous;
une couche photoactive comprenant la composition photoactive selon la revendication 1;
une couche de transport d'électrons; et
une cathode.

6. Dispositif selon la revendication 5, dans lequel, dans la composition photoactive, R¹ à R⁴ sont indépendamment choisis dans le groupe constitué par phényle, biphényle, terphényle, quaterphényle, naphtyle, phénanthryle, naphtylphényle, phénanthrylphényle, carbazolyle et carbazolylphényle.

7. Dispositif selon la revendication 5, dans lequel, dans la composition photoactive, l'amine aromatique est choisie dans le groupe constitué par la N,N'-diphényl-N,N'-bis(3-méthylphényl)-[1,1'-biphényl]-4,4'-diamine (TPD), le 1,1-bis[(di-4-tolylamino)phényl]cyclohexane (TAPC) et la N,N'-bis(naphtalén-1-yl)-N,N'-bis-(phényl)benzidine (NPB).

8. Dispositif selon la revendication 5, dans lequel le dopant est une matière phosphorescente.

9. Dispositif selon la revendication 8, dans lequel la matière dopante est un complexe cyclométallé de Ir.

10. Composition photoactive selon la revendication 1, dans laquelle le premier hôte a la formule I et R¹ à R⁴ sont indépendamment choisis dans le groupe constitué par naphtyle, naphtylphényle, phénylnaphtyle, carbazolyle, triphénylamino, arylanthracényle, et un groupe ayant la formule II.

11. Composition photoactive selon l'une quelconque des revendications 1 à 4 et 10, dans laquelle le rapport pondéral de la première matière hôte à la seconde matière hôte est dans la gamme de 90:10 à 70:30.

12. Composition photoactive selon la revendication 1, dans laquelle le premier hôte est choisi parmi

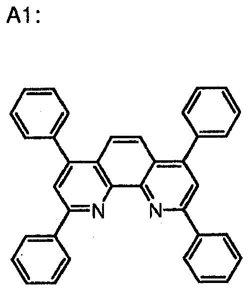

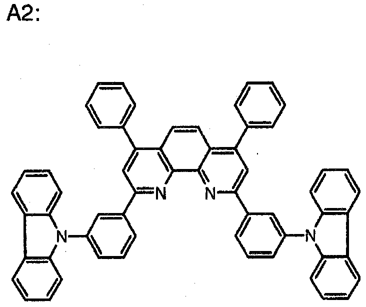

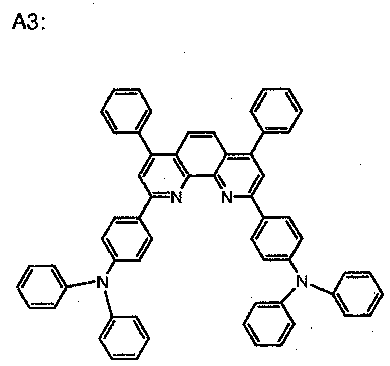

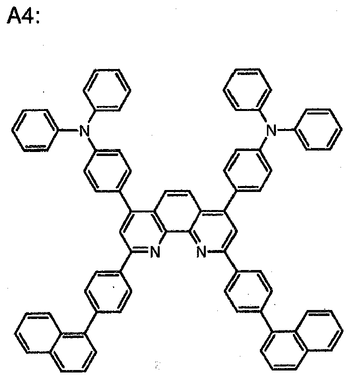

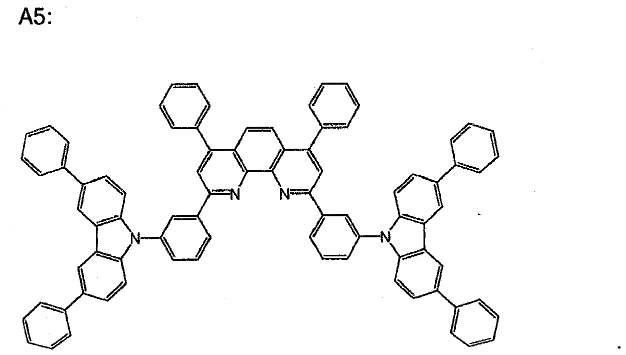

13. Dispositif luminescent organique selon la revendication 5, dans lequel, dans la composition photoactive, le premier hôte a la formule I et R¹ à R⁴ sont indépendamment choisis dans le groupe constitué par naphtyle, naphtylphényle, phénylnaphtyle, carbazolyle, triphénylamino, arylanthracényle, et un groupe ayant la formule II.

14. Dispositif luminescent organique selon l'une quelconque des revendications 5 à 9 et 13, dans lequel, dans la composition photoactive, le rapport pondéral de la première matière hôte à la seconde matière hôte est dans la gamme de 90:10 à 70:30.

15. Dispositif luminescent organique selon la revendication 5, dans lequel, dans la composition photoactive, le premier hôte est choisi parmi
